# EUROPEAN PATENT APPLICATION

(11) **EP 3 483 633 A1**
(43) Date of publication of application: **15.05.2019**
(21) Application number: 17382769.2
(22) Date of filing: 14.11.2017
(51) Int. Cl.: G01T 1/20, G01T 1/24

(54) **A METHOD TO REDUCE THE NUMBER OF SIGNALS TO BE READ OUT IN A DETECTOR**

(71) Applicant: General Equipment for Medical Imaging, S.A., 46022 Valencia (ES)
(72) Inventor: GONZÁLEZ MARTÍNEZ, Antonio Javier, 46022 Valencia (ES); GONZÁLEZ MONTORO, Andrea, 46022 Valencia (ES); BENLLOCH BAVIERA, José María, 46022 Valencia (ES); HERNÁNDEZ HERNÁNDEZ, Liczandro, 46022 Valencia (ES); BARBERÁ BALLESTER, Julio, 46022 Valencia (ES)
(74) Representative: Cueto, Sénida

(57) **Abstract**

The present invention refers to a method to reduce the number of signals to be read out in a detector characterized in that it comprises using a lower photosensor granularity at least at the center center obtaining a granularity degree at the photosensor that is edge dependent, wherein the granularity at the detector corners can be higher than at any other detector zone or wherein the granularity at the detector edges can be higher than at any other detector zone, and wherein the number of signals to be read out is reduced by joining signals in at least the center zone of the detector, or is reduced by using different photosensor elements at the center of the photosensor with regard to the remaining photosensor zones, and its use in nuclear medicine imaging techniques.

## Description

### Background of the invention

Nuclear medicine techniques, such as PET or SPECT provide quantitative functional tomographic information on the metabolic and physiological processes that take place in the body through the spatial distribution of a tracer that has been supplied to the patient. The tracer is a molecule from which some of its atoms have been replaced by radioactive isotopes and once incorporated into the organism the metabolic processes move it to the area of interest. There are several factors that determine the quality of the image in a nuclear medicine device such as a PET scanner, namely the system sensitivity, spatial resolution, energy resolution, scattered radiation. The different parameters are interdependent and a compromise has to be found among them for a good image quality.

When the gamma ray detectors use scintillation crystals, to stop these gamma rays, there are typically two types of scintillators types used namely crystal arrays or monolithic blocks. Of course different scintillation material can indistinctively be used such as LYSO, BGO or LaBr to name but a few. In gamma ray detectors based on monolithic scintillators and a position sensitive photosensor, edge effects tend to compromise its performance. This occurs due to the truncation of the light distribution near the crystal edges. Here, high photosensor and readout granularity helps to better characterize these events. When using such high granularity photosensors and readout electronics, it is possible to improve the detector block performance, including its edges, but at the cost of more photodetector components and/or readout channels.

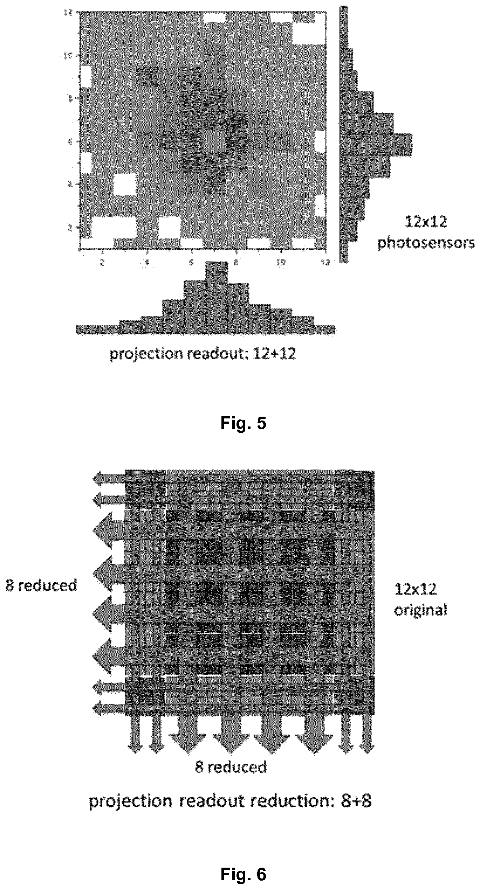

The best approach is to read out every single element of the photosensor array (n × n, n² signals to be considered by the data acquisition system), but this typically implies digitizing a huge number of signals. This array could be, a position sensitive photomultiplier tube (PSPMT) or a Silicon Photomultiplier (SiPM) matrix, to name but a few. Novel techniques have lately been used to reduce the number of channels to be digitized. One of the oldest approaches is the so-called Anger logic where all photosensor signals are combined using a resistor network and reduced to only 4. This approach can hardly provide information on the photon depth of interaction within the scintillation volume (monolithic blocks), except of a modification of the resistor network. An improved method with respect to the Anger logic is to digitize every row and column of the photosensor array. This means digitizing a number of channels of 2 × n (Figure 5 of the present application). This approach has shown good results both using crystal arrays and especially with monolithic blocks since it allows characterization of the light distribution.

Patent US6747263 by Popov describes a resistor network with the ability to isolate each photosensor output when injected into the corresponding row and column simultaneously. In the US patent US2013/0293296 A1, Proffit uses a similar approach but exchanging the resistors by diodes in order to be able to suppress certain noise present in former photosensors made out of solid-state technology (SiPM). In some cases, the performance of the 2 × n approach is very similar to the n × n approach, since further information is redundant.

It has been shown in the literature that the 2 × n approach can be a good estimator for the light distribution projections onto the X and Y axes of a scintillation crystal. Again, the larger the granularity of the photosensor and, therefore, of the readout, the better characterization of the light distribution. Characterization means determining the centroid and the depth of interaction (in monolithic blocks) of the impinging photon (A. Gonzalez-Montoro, et al., IEEE Trans. Radiation Plasma Medical Sci., 1, pp. 229, 2017; A.J. Gonzalez, et al., IEEE Trans. Nucl. Sci., 63, pp. 2471, 2016.

It is also well known by the researchers and technical experts that the amount of data to be handled in the process of determining the 3D (planar and depth of interaction) photon impact position within the scintillation volume is enormous and any achievement in the reduction of data, this is, in the number of signals to be handled, will be a significant contribution to the art, especially taking into account the relevance of these techniques involved in human health.

There is a continuous general need in the field of image reconstruction, and particularly in nuclear imaging medicine to further reduce the amount of data to be handled without impairing the quality of the images obtained.

In order to improve the final reconstructed image quality there is a need to take into account not only the light received by the central area of the detector module, but also to take into account the light received near the edges of the detectors, that usually does not count in the construction of the images.

The present invention provides a method that allows to take into account the radiation received by the detector edges -laterals and corners, and especially the corners - and not only the detector center. Thanks to the use of the whole crystal volume as useful data the quality of the image obtained is improved.

The present invention provides a better result at the detector edges than the methods known so far when using the same number of signals.

The present invention keeps a good detection performance, especially at the crystal edges, by significantly reducing the number of signals to be digitized. In the particular case of using monolithic crystals this is obtained by better characterizing the light distribution at those edges.

The detector block, or detector module, used according to the present invention has the capability to resolve events at the crystal edge, using a particular readout scheme with high performance.

### Definitions used

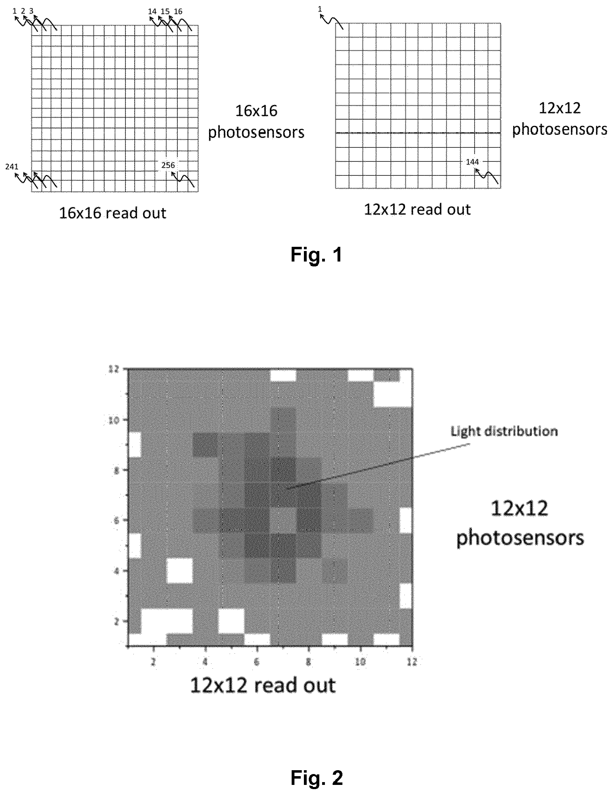

"edge effect" is defined as the loss of resolution towards the edge of a crystal compared to the resolution of the other crystal zones, what means that the minimum separation between two points must be higher in order to have the two points resolved,
"granularity" is the scale or level of detail in a set of data. The greater the granularity, the deeper the level of detail, in the case of number of signals received by a radiation detector, to be processed, the "granularity" refers to the number of signals per volume element,
"active area" is the area of the photosensor collecting scintillation light when using scintillation material,
"readout electronics" is the electronics behind the photosensor array in a detector module or detector block that allows to process the radiation measured by the photosensor and makes it possible to obtained a detector image,
"readout channels" refers to the number of signals coming out of the readout electronics, "maximal granularity" refers to the level of detail with which the radiation intensity is processed when there is not applied any reduction readout or reduction of the number of signals (see Figure 1),
"detector block", "detector module" or "detector" are used indistinctly in the present application,
"projection readout" refers to summing all the signals of a row or a column of the photosensor array in a single point, such as an amplifier in the case converting current into voltage (see Figure 5).
"reduction readout" refers to a readout electronic that allows localizing the impact position in the detector block with a number of readout channels smaller than the "maximal readout".
"projection reduction readout" refers to summing all the signals of a row or a column of the photosensor array in a single point, such as an amplifier in the case converting current into voltage, after having reduced the number of signals by joining signals (first alternative of the present method), or after having reduced the number of signals by using different phososensor elements (different in size, shape, or both) (second alternative of the present method), or after having reduced the number of signals by a combination of the first and second alternative.

Since a detector includes a photosensor as one of its components, in this application, an action carried out on the photosensor is sometimes referred to as an action or operation carried out on the detector. Both are to be understood as equivalent because said action on the photosensor has the same consequences on the detector.

### Description of the invention

The present invention refers to a method to reduce the number of signals to be read out in a detector, preferably, a radiation detector, characterized in that it comprises using a lower granularity at the photosensor center than at the photosensor corners, or lower than at the photosensor edges (corners and laterals) by means of a granularity degree at the photosensor that is edge dependent. This means that there is an edge dependent granularity degree at the photosensor, or, there is a granularity gradient.

The method to reduce the number of signals to be read out in a detector characterized in that it comprises using a lower granularity at least at the photosensor center than at the photosensor edges obtaining a granularity degree at the photosensor that is edge dependent.

The granularity at the detector corners can be higher than at any other detector zone.

Other embodiments refer to the method wherein the granularity at the detector edges is higher than at any other detector zone.

Reducing the number of signals to be read out can be achieved in two ways:
- A first alternative comprises to join signals using such granularity gradient that consists of having more signals joined at least at the photosensor center.
- A second alternative comprises the use of different photosensor elements, that can be different in size, geometry, or both, for example photosensor elements of different sizes within the detector, for instance larger at the center with regard to the remaining detector zones.

"Edge dependent" means using a higher granularity at the detector corners and laterals than at the detector center, or at least at the detector corners, thus reducing the number of signals to be transmitted from the photosensor array to the readout electronics by the photosensor elements.

### First alternative

### Joining signals

According to the first alternative, more specific embodiments comprise to join the signals at the detector center in groups of at least two.

According to the first alternative, additional specific embodiments comprise to join the signals at the detector center, and at the detector laterals in groups of at least two.

The number of signals to be read out can be reduced by joining signals:
- at the detector center, or
- at the detector center and at the detector laterals, or
- at the detector center, at the detector laterals and at the detector corners.

The number of signals to be read out is reduced by joining the signals in groups of at least two.

According to the first alternative, additional specific embodiments comprise to join the signals at the detector center, and at the detector laterals and corners in groups of at least two. Usually, each pixel or element of the photosensor array in the radiation detector, is connected to a readout channel, but according to the first alternative of the present invention, pixels from certain number of photosensor elements are connected to a single readout channel, reducing in this way the number of readout channels to be processed.

Based on this fact, the number of signals to be read out is reduced by merging (joining) the signals coming from the photosensor elements located at certain zones of the photosensor array, into groups of at least two signals, for their further processing in the reconstruction process of photon impact determination and, in some cases, keeping the original signals from the remaining photosensor zones.

Using higher granularity at the detector corners and detector laterals than at the detector center, also means in a particular case, providing information for each photosensor element for which the signals at the corners are kept, but those signals coming from the photosensor elements located at the laterals and at the center of the photosensor array are merged in groups of at least two.

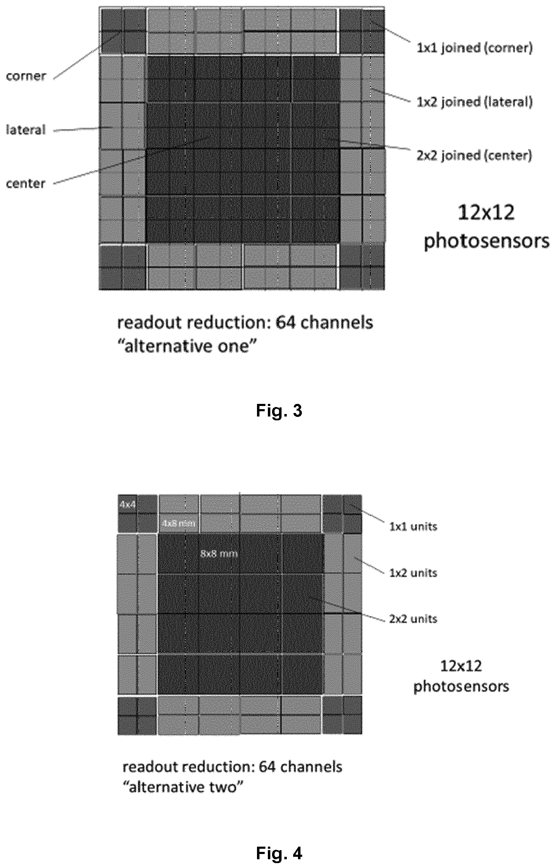

According to additional specific embodiments, the reduced readout, the number of signals is reduced by merging the signals from the photosensor elements located at the photosensor laterals in the direction perpendicular to the detector block center, and merging the signals from the photosensor elements located at the center block (see Figure 3).

Further exploring the n × n approach, the invention also considers an embodiment reducing the number of signals but again keeping a good sampling of the scintillation light in monolithic crystals. In a photosensor array of 12 × 12 elements with 3 × 3 mm² and 4 mm pitch, or 4 × 4 mm² and also 4 mm pitch, the number of total photosensor elements is 144. As shown in figure 4, by keeping the sampling at the corners (1 × 1 elements), merging in 1 × 2 elements photosensor at the sides and 2 × 2 at the center, it is possible to reduce from 144 to only 64 elements without compromising the characterization of the scintillation light and, therefore, photon impact localization. This example could be extended to smaller and also larger number of elements. As described above, this approach could also be put into practice by using non-regular elements (different shapedphotosensor elements). This is a reduction in signals larger than 50%.

### Second alternative

### Different photosensor elements

This second alternative comprises reducing the number of signals by using *different* photosensor elements, wherein *different* means that they have different sizes, or different geometry, or a combination of both.

In particular embodiments, the number of signals to be read out is reduced by using different photosensor elements at the center of the photosensor with regard to the remaining photosensor zones.

Using photosensor elements of different sizes within the radiation detector, means that they are larger at the center than at the remaining zones of the detector (Figure 4). According to the second alternative, more specific embodiments comprise using smaller photosensor elements at the detector corners than at the detector center and detector laterals.

As an example, the number of signals to be read out is reduced by using smaller photosensor elements at the detector corners than at the detector center and detector laterals.

According to the second alternative, additional specific embodiments comprise using smaller photosensor elements at the detector corners, larger photosensor elements at the detector laterals and even larger photosensor elements at the detector center. According to this second alternative of the method, the number of signals to be transmitted from the photosensor array to the readout electronics by the photosensor elements, is reduced by using a photosensor array with photosensor elements of different sizes in a matrix configuration. The different sizes mean smaller sizes at least at the corners the edges (laterals and corners) and larger at the center of the photosensor active area.

Specific additional embodiments for this second alternative refer to the case wherein photosensor elements of different geometry - shape - are used. For example, part of the photosensor elements can be rectangular and the remaining ones can be non-rectangular.

Additional particular embodiments of the method refer to the case where the first and the second alternative are combined: the number of signals to be read out reduced in this case:
- by joining signals at least at the photosensor center,
- and using *different* photosensor elements (different in size, in shape or both) within the detector, more particularly different photosensor elements at the center of the photosensor with regard to the remaining photosensor zones.

### Third alternative -"projection reduction readout"

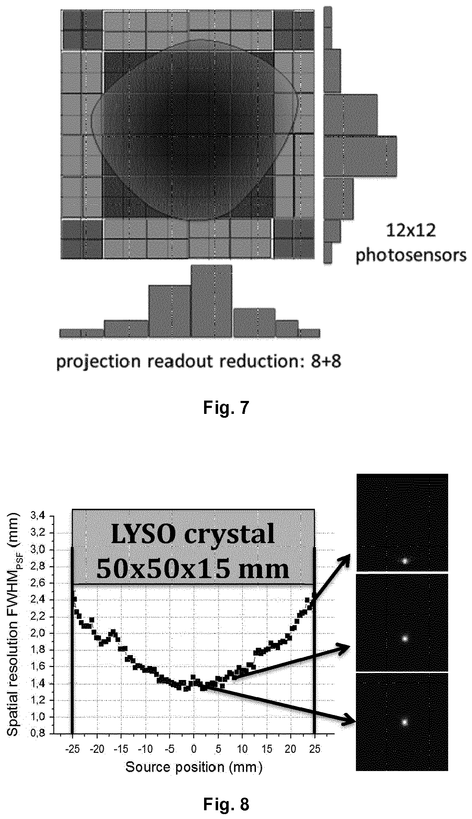

A third alternative of the method comprises carrying out any of the two alternatives above and further applying a projection readout by summing all the signals for each row and all the signals for each column giving rise to an additional reduction of the number of signals to be processed by the readout electronics of the detector. If the first alternative is followed, multiple original rows (or columns) would be summed to one end point (Figure 6). In the case of applying the third alternative to the second one, the wider photosensor elements at the center contribute to one end point (Figure 7).

This third alternative comprises the operation called "projection", this is summing the signals of each row and each column of the photosensor array, which have previously undergone the operation of one of the first or second alternatives explained above, i.e., the number of signals has previously been reduced according to the first, or of the second method alternative.

An embodiment of the invention referred to the third alternative applied to the first one, is for instance considering the case of a photosensor array with identical elements and pitch (center to center distance). This embodiment will consider whatever the particular passive components are used (diodes, resistors, capacitors, combinations of those, etc...). Such an embodiment would keep the edge sampling of the photosensor elements size. For instance, in a 12 × 12 array, the 2 rows (and columns) at the edges will be normally read, but the 8 central ones will merged into 4 readout signals. Therefore, the number of signals to digitize reduces from 24 (2 × n) to only 16 (8 rows plus 8 columns). This is approximately a 30% reduction in the number of signals.

The projection readout can be applied to any one of the specific additional embodiments to the first or to the second alternatives as explained above. It also can apply to the second alternative wherein photosensor elements of different geometry - shape - are used.

The projection readout can also be applied to the additional particular embodiments of the method wherein the first and the second alternative are combined as mentioned above.

The application of the projection readout by summing all the signals for each row and all the signals for each column can be carried out previous to the joining of signals defined above in the first alternative.

A preferred embodiment of the invention refers to the method further comprising:
two previous steps of:
   - detecting gamma radiation coming from a gamma radiation source by means of at least a detector module,
   - measuring radiation signals at the photosensor array prior to reducing number of signals as defined in any of the embodiments described herein,
   - and a final step of reconstructing the impinging position of the gamma radiation.

For any of the two main alternatives of the method: merging of signals by connecting photosensor elements or by using *different* photosensor elements of, the detector can be a gamma ray detector that comprises a scintillation block and a photosensor array.

The scintillation block can be a monolithic crystal. The monolithic crystal can undergo any type and surface treatments.

The scintillation block can also be an array of pixelated crystals. Other scintillation block approaches, different from the most typically used (monolithic or crystal array) could also be used and would also benefit from the present invention.

The invention also has as an object the use of the method defined above in nuclear medicine imaging techniques, more particularly in the process of reconstructing the impinging position of the gamma radiation emitted by a radiation source and measured by a nuclear imaging device.

The present invention also refers to a process for the reconstruction of the radiation impact within the detector, particularly data obtained by a nuclear medicine imaging device, said process comprises carrying out the method to reduce the number of signals defined above.

The process for reconstruction of the radiation, more particularly, gamma ray, impact determination comprises:
- detecting the radiation coming from a radiation source by means of at least a detector module,
- measuring radiation signals at the photosensor array
- reducing the number of signals to be read out obtaining a lower granularity at the photosensor center than, at least, at the photosensor corners, that is a granularity degree at the photosensor that is edge dependent.

More particular embodiments of the process are defined by the dependent claims at the end of the description.

Reducing the number of signals to be read out obtaining a granularity degree at the photosensor, that is edge dependent can be carried out:
- by joining signals, joining more signals at the detector center, than at the edges (laterals and corners),
- by using *different* (different sizes and/or shape) photosensor elements at the detector center than at the detector corners and laterals.

Specific embodiments of the process of the present invention correspond to the specific embodiments of the method defined above.

The present invention also refers to a detector module, more particularly a detector module for a nuclear medicine imaging device, to carry out the method, or the process, defined above.

More particular embodiments of the detector module are defined by the dependent claims at the end of the description.

The detector module can comprise photosensor elements with a larger active area at the center of the photosensor and smaller active area and the corners, or at the corners and laterals. This feature results in a higher granularity at the detector corners, or at the corners and laterals, than at the detector center.

Merging photosensor elements at certain zones of the photosensor array results in the merging of the signals coming from said photosensor elements. Therefore, reference is made to the merging of photosensor elements or merging of signals indistinctly in this specification.

The detector module can comprise a photosensor array wherein photosensor elements from certain zones of the array are connected in - or merged into - groups giving rise to a reduced number of signals, what will be appropriate for carrying out the method of the invention according to the first alternative above, or, in another embodiment, the detector module can comprise photosensor elements of different sizes, what will be appropriate for carrying out the method of the invention according to the second alternative above.

The third alternative of the method defined above can be carried out with a detector module appropriate for carrying out the method as per the first or second alternative, as defined in the preceding paragraph, that further comprises a readout electronics with capability of projecting the photosensor elements onto rows and columns carrying out a reduction readout. These embodiments of the detector module are explained in detail hereinbelow.

### Detector module for carrying out the first alternative of the method above:

In this case of the detector module, the larger active area at the center is obtained by summing the active area of two, or more, photosensor elements.

According to more specific embodiments, the detector module comprises a photosensor array wherein photosensor elements located at the photosensor array center are merged into groups of at least two, and photosensor elements located at the photosensor array corners and laterals are not merged.

According to additional specific embodiments, the detector module comprises a photosensor array wherein photosensor elements located at the photosensor array center are merged into groups of at least two, photosensor elements located at the photosensor array corners are not merged and those located at the laterals are merged in a smaller degree than at the center.

According to additional specific embodiments, the detector module comprises a photosensor array wherein photosensor elements located at the photosensor array center are merged into groups of at least two, photosensor elements located at the photosensor array corners and laterals are merged in a smaller degree than at the center.

### Detector module for carrying out the second alternative of the method above:

In this case of the detector module, the larger active area at the center is obtained by using photosensor elements of different sizes within the photosensor array.

The elements of the photosensor array are larger at the center area, and smaller at the corners and laterals.

The elements of the photosensor array can also be larger at the center area, smaller at the laterals than at the center and even smaller at the corners.Detector module for carrying out the third alternative of the method above:

In this case of the detector module can be a detector module appropriate for carrying out the first alternative of the method, or the second alternative of the method, and further comprising a readout electronics with capability of projecting the photosensor elements onto rows and columns carrying out a reduction readout. These embodiments of the detector module are explained in detail hereinbelow.

The detector module can comprise a readout electronics that provides information for each row and column of the photosensor array (third alternative of the method explained above as applied to the first main alternative), where the edge row and columns are kept with the ideal, or maximal granularity, but those rows and columns towards the center are merged, for instance 2 to 1, depending on the number of signals.

According to more specific embodiments the elements at the center of the photosensor array are connected at least in pairs to a readout channel (row and column pairs), whereas the photosensor elements at the laterals and corners of the photosensor array are connected minimum to a readout channel. Such higher photosensor granularity at the edges allows one for the accurate sampling of the scintillation light. In the case of using monolithic crystals, this results in a better characterizing the effect produced by the truncation of the scintillation light distribution at the crystal edges.

According to additional specific embodiments, the detector module comprises a photosensor array wherein the photosensor elements (row and columns) located at the photosensor array corners are not merged, photosensor elements located at the photosensor laterals are merged (into groups of at least two) in the direction perpendicular to the center block, and photosensor elements located at the center block are merged in both directions

For instance, there are commercially available photosensor arrays, also some custom made, with 12 × 12 elements of 3 × 3 mm² (or 4 × 4 mm²) each, and with a pitch close to 4 mm. These are theoretical numbers, although similar ones do really exist. A projection readout electronics as shown in Figure 4 would generate 12 + 12 signals (2 × n readout). In a specific embodiment of the third alternative of the present invention, lateral signals of the projection readout will remain with ideal sampling but center ones merged from 2 to 1. Therefore, only 8 + 8 signals could be generated. At the edges the 4 mm pitch is kept, but at the photosensor center this increases to 8 mm.

According to additional particular embodiments, the detector comprises a photosensor with photosensor elements of different sizes in a matrix configuration. The different sizes mean smaller sizes at the edges (at the corners, or at the laterals and corners) and larger at the center of the photosensor array. This alternative will satisfy small sampling at the edges but larger at the center.

According to additional particular embodiments of the detector module, different size photosensors could also be used (third alternative applied on the second one) by using photosensor elements of 3 × 3 mm² at the edges, 2 on each edge with 4 mm pitch, and 4 rows and columns of 6 × 6 mm² active area photosensor elements at the center with about 8 mm pitch.

In order to increase the total active area coverage of the photosensor array (ratio between true photosensor active area over geometrical dimensions), the photosensor could also have 2 elements at each side of 4 × 4 mm² with a pitch of ideally 4 mm and elements at the center with 8 × 8 mm² with pitch of 8 mm.

The final number of signals provided by the readout electronics when enabling the projection reduction readout (third alternative applied to the first one) can be mathematically found as follows: In the case of applying this reduction readout invention to a photosensor array with an even number of elements and the same for both rows and columns, one can deduce the number of total signals T = (P+R)/2 where P is the maximum number of signals to be processed (24 for an array of 12 × 12 elements, or 32 for an array of 16 × 16), and R the number of non-merged signals. Therefore, for the aforementioned case P = 24 and R = 8 and, then T = 16. Another example, in a case with a 16 × 16 SiPMs, leaving free the 3 edge signals, T = (32 + 12) / 2 = 22.

In the case of crystal arrays: If a crystal array is used instead of a monolithic crystal, the crystal array is coupled to a photosensor array and the reduction readout is used, it is also possible to resolve well all crystal pixels without significant performance degradation. Only at the detector block center, a higher compression of the crystal pixels is observed due to the new larger pitch size.

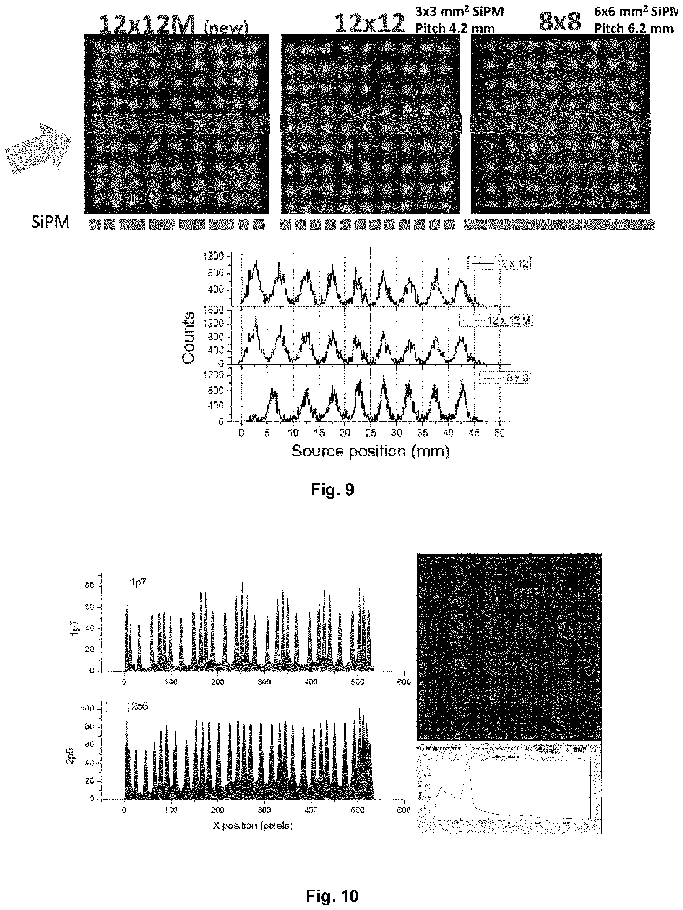

A projection readout of identical photosensor elements but with larger pitch (either using larger photosensor elements or larger pitch) to cover the same active area but resulting in a reduced number of signals, will not produce successful results. Reducing the number of elements, keeping constant the active area, means increasing the distance from center to center photosensor and, therefore, the edges will suffer from poor resolution (larger sampling binning size). An example of this realization is shown in Figure 9, right panel. In this particular panel an 8 × 8 SiPM array with about 6 × 6 mm photosensors is used, and a projection readout applied (8 + 8 signals). Comparing with the left panel, that uses the third alternative applied to the first one, projection readout of merging signals, also resulting on 8 + 8 final signals, allows one to resolve impacts at the very edge of the crystal, in contrast to the right panel that misses those signals.

For any of the three main embodiments, i.e., with a photosensor array having photosensor elements connected to each other in certain areas, photosensor elements of different sizes, or projecting those onto rows and columns, the detector can be a gamma ray detector that comprises a scintillation block and a photosensor array.

The detector can be a gamma ray detector that comprises a pixelated crystal or crystal array and a photosensor array. The crystal array may have any pixel size, height, and may have undergone any treatment.

The present invention permits to properly characterize the scintillation light distribution in detector blocks for gamma ray imaging, using monolithic scintillation crystals, reducing the number of total signals.

### Brief description of the drawings

Figure 1 shows the maximal readout channels for two examples of photosensor arrays, left 16 × 16 channels read out individually, and right 12 × 12 channels read out individually.
Figure 2 shows an example of the light distribution in a monolithic crystal when reading out 12 × 12 channels. The grey scale shows SiPMs with more or less scintillation photons collected.
Figure 3 shows the embodiments of the alternative one of the method, where SiPM signals of nearby photosensors are combined to provide a single output. A higher number of photosensor elements are combined at the center (here 4 into 1) in this example, and less at the laterals (2 into 1). Corner photosensors are not combined. The figure also shows the meaning of corner, lateral and center. In this example a reduction from 144 photosensor elements (maximal number of signals) is reduced to 64.
Figure 4 shows the embodiment in which photosensors of different size are combined, following the so-called alternative two. The example also reduces from the 12x12 maximal number of outputs to 64, combining for instance, 4x4 mm, 8x4 mm and 8x8 mm photosensors. Larger at the center that at the corners, in order to keep the best sampling where the scintillation light is truncated in the case of using monolithic crystals.
Figure 5 does not show one of the embodiments, but it represents the so-called projection readout for the 12 × 12 SiPM array example. Therefore, here 12+12 signals would be readout out. The 3D light distribution in the map is projected onto the X and Y axes.
Figure 6 shows the third alternative, based on the 12 × 12 SiPM photosensor matrix. In this figure we have used the second method alternative first, and then the projected readout electronics. Therefore, we reduced from 144 signals to only 16.
Figure 7 shows again the representation depicted in Figure 6 but with the projected light distributions composed by 8 signals from the rows and 8 from the columns.
Figure 8 shows the result of using an embodiment like the one shown in Figure 1, where it is possible to resolve well impacts across the whole crystal volume. This was done for a 50 × 50 × 15 mm thick LYSO-type crystal. A collimated source was moved from one side of the crystal to the other using the reduction readout and a photosensor array of 12 × 12 elements. The plot shows the measured spatial resolution (measured through the FWHM of the distribution) as a function of the beam position.
Figure 9 shows an example of performance of one of the embodiments of the invention and comparison with alternative approaches. Left, results obtained with the described invention using 12 × 12 photosensor and the reduction readout. Center, using a readout as proposed by Popov or Proffitt. Right, an array of 8x8 elements with larger active area and constant larger pitch. It is observed that left and center provide very similar results, (but left with a 30% of signal number reduction (what is a substantial advantage over the prior art), whereas right shows the lack of resolving power at the left edge due to the wider sampling there. Bottom, profiles of the central row of sources for the three cases. Here, it is observed how the source closest to the left edge (2.5 mm from crystal edge) can be resolved for the standard project readout (12+12 signals), but also for the proposed third alternative invention with only 8+8 signals without appreciable deterioration of the performance at any detector location. However, the standard projection readout with 8+8 does not solve these sources near the edge.
Figure 10 shows an example for one of the embodiments, as shown in Figure 1, but using a crystal array instead of a monolithic block. Also for these types of scintillators, the invention offers an advantage over conventional methods, due to the reduction of signals without compromising the performance. On the left side, a row of pixels is shown for two acrylic windows thickness placed in between the crystal array and the photosensor (1.7 mm and 2.5 mm). Right, flood map for a 32x32 crystal matrix (1.6 mm pitch) and its energy spectra.

With the information given in the references 1 and 2, mentioned above, that explain how to obtain the 3D photon impact position, especially in a monolithic crystal, and the description, the method of the invention can be put into practice.

An illustrative example is described hereinbelow.

### Example

### Experimental set-up

An experiment with two identical detector blocks, working in coincidence, has been designed. Two LYSO scintillation blocks (50×50×15 mm³) with specific surface polishing and treatments were used.

Each detector block also includes an array of SiPMs as depicted in Fig. 1 right. The photosensor matrix is composed of 12 × 12 SiPMs photosensors with 3×3 mm² active area each, and a pitch of 4.2 mm. Instead to reading all photosensors individually (144 signals), each SiPM has been connected to the aforementioned projection readout circuitry that provides scintillation light profiles in the X and Y axes. The readout electronics according to third alternative embodiment reduces the 12 signals for each projection to only 8, resulting on a total of 8+8 outputs per photon impact. This reduction is based on keeping the 2 lateral row and columns, but merging the 8 central ones from 2 to 1. This still preserves the good sampling of the light at the crystal edges and, thus, a good characterization of the effect produced by the truncation of the scintillation light therein. The proposed readout scheme makes it possible to reduce the total number of signals of a detector of 144 photosensors to only 16. The performance of the proposed detector block module including the projection reduction readout system, has been compared to a standard 8×8 SiPMs photosensors with a 6×6 mm² active area, and a pitch of 6.33 mm.

The performance of the detector block described above was evaluated by means of the spatial, energy and DOI resolutions. Perpendicular to entrance face and lateral incidence measurements to the crystal were carried out. The module under study was irradiated with an array of 11×11 ²²Na sources, 1 mm in diameter and 1 mm height each (4.6 mm pitch), placed in front of a Tungsten collimator (24 mm thick, 1.2 mm diameter holes), which was in contact with the crystal. The centroids of the measured scintillation light distributions, through the projection readout circuit, are calculated using the center of gravity methods. The photon impact DOI is estimated by the ratio of the sum of all 8 signals (photon energy, E) to the maximum signal value (*E*/*Imax*). During the data processing, each detector area is subdivided in 600×600 virtual pixels, and a software collimation was applied. An energy window of 15% at the 511 keV peak was also applied in the data analysis. The collimation aperture must guarantee the best compromise between the detector spatial resolution and the measurement statistics of the analyzed measurement.

The measured detector spatial resolution was evaluated using the imaged 11×11 ²²Na collimated sources, as shown in Fig. 11 left. We calculated the centroid of each source in channels, as shown in the profile of the top panel in Fig. 11 right, using multi-Gaussian distributions. After the calibration to metric units, it is possible to obtain the measured detector spatial resolution for each source as the FWHM. The spatial resolution for each source was calculated as the average of the X and Y projections, and as a function of the DOI layer. The top right panel in Fig. 11 shows the profile of the central row of sources calibrated into mm, the 11 sources can be well distinguished. Right-bottom, DOI distribution of a source placed at 15 mm from the edge. The energy resolution is determined as FWHM/E_{centroid}. This was done for each selected DOI range.

Traditionally, in PET systems based on monolithic scintillators, events close to the crystal edge are hardly considered as good data for the image reconstruction due to its poorer characterization. In order to study how close to the crystal edge can events be properly characterized, a second set of experiments was carried out using normal incidence by means of a pinhole Tungsten collimator with 30 mm thickness and with a drilled hole of 2 mm diameter together with a small size ²²Na source. In these experiments the source was displaced in small steps of 0.5 mm across the entire X axis of the crystal.

To provide accurate DOI resolution values, lateral incidence measurements were carried out in steps of 1 mm also using the pinhole collimator. ROIs of 4 × 4 mm² were carried out at step distances of 5 mm from the crystal edge, reaching the crystal center. This allows one characterization of the DOI in the whole volume of the scintillator.

Using the impact DOI information for each impact, we have split the data into three DOI regions, namely DOI1 (entrance), DOI2 and DOI3 (exit), which correspond to crystal depths of 15-10 mm, 10-5 mm and 5-0 mm (near the photosensor), respectively. This allows obtaining three different flood maps.

### Results

An overall good performance including, depth of interaction information has been achieved. We achieved a spatial resolution of about 1.8 mm FWHM for the whole scintillation volume, with an average energy resolution of 13% FWHM and a photon depth of interaction resolution (FWHM) of 3.7 mm.

The main advantages of the detector block according to the invention is a new readout electronics permits to reduce the 144 photosensor elements information to only 8+8 signals without significant detector performance degradation.

This approach also allows for resolving radioactive sources in the whole volume of the proposed crystal, but with a significant reduction of readout signals to be processed (from 144 to 16).

Figure 9 depicts the results of an experiment carried out comparing the third alternative (projection reduction readout electronics) on a 12 × 12 photosensor with a more used projection readout for both 12 × 12 and 8 × 8 SiPM array. That means using 8+8, 12+12 and 8+8 signals respectively. One of the columns of sources was placed at 2.5 mm from the crystal edge. Both the projection reduction readout and the projection readout for the 12 × 12 array made it possible to resolve these impacts at 2.5 mm from the edge. The 8 × 8 array with also 8+8 signals did not allow one for this. Therefore, the current invention shows how to reduce the number of channel without performance decrease at the edges.

## Claims

1. A method to reduce the number of signals to be read out in a detector **characterized in that** it comprises using a lower photosensor granularity at least at the center center obtaining a granularity degree at the photosensor that is edge dependent.

2. The method according to claim 1, wherein the granularity at the detector corners is higher than at any other detector zone.

3. The method according to claim 1, wherein the granularity at the detector edges is higher than at any other detector zone.

4. The method according to any of claims 1 to 3, wherein the number of signals to be read out is reduced by joining signals in at least the center zone of the detector.

5. The method according to any of claims 1 to 3, wherein the number of signals to be read out is reduced by using different photosensor elements at the center of the photosensor with regard to the remaining photosensor zones.

6. The method according to claim 4, wherein the number of signals to be read out is reduced by joining signals:
- at the detector center, or
- at the detector center and at the detector laterals, or
- at the detector center, at the detector laterals and at the detector corners.

7. The method according to claim 5 or 6, wherein the number of signals to be read out is reduced by joining the signals in groups of at least two.

8. The method according to claim 5, wherein the number of signals to be read out is reduced by using smaller photosensor elements at the detector corners than at the detector center and detector laterals.

9. The method according to claim 5, wherein the number of signals to be read out is reduced by using smaller photosensor elements at the detector corners, larger photosensor elements at the detector laterals and even larger photosensor elements at the detector center.

10. The method according to claim 5, wherein the number of signals to be read out is reduced by using photosensor elements of different shape within the detector.

11. The method according to any of claims 4 or 5, wherein the number of signals to be read out is reduced by:
- joining signals in at least the center zone of the detector and
- by using different photosensor elements at the center of the photosensor with regard to the remaining photosensor zones.

12. The method according to claim 4, 5 or 11, wherein the number of signals to be read out is further reduced by applying a projection readout by summing all the signals for each row and all the signals for each column giving rise to an additional reduction of the number of signals to be processed by the readout electronics of the detector.

13. The method according to claim 12, wherein the application of the projection readout by summing all the signals for each row and all the signals for each column is carried out previous to the joining of signals defined in any of claims 4 or 6.

14. The method according to any one of the preceding claims, wherein the detector is a radiation detector.

15. The method according to claim 14, wherein the detector is a gamma radiation detector.

16. The method according to claim 15 wherein the radiation detector is a gamma ray detector that comprises a scintillation block and a photosensor array.

17. The method according to claim 16, wherein the scintillation block is a monolithic crystal or an array of pixelated crystals.

18. The method according to claim 15 further comprising:
- two previous steps of:
- detecting gamma radiation coming from a gamma radiation source by means of at least a detector module,
- measuring radiation signals at the photosensor array prior to reducing number of signals as defined in any of claims 1 to 14,
- and a final step of reconstructing the impinging position of the gamma radiation.

19. A process for the reconstruction of the impinging position of a gamma ray in a gamma radiation detector comprising:
- detecting the radiation coming from a radiation source by means of at least a detector module,
- measuring radiation signals at the photosensor array
- carrying out the method defined in claim 1 of reducing the number of signals to be read out obtaining a lower granularity at the photosensor center than at the photosensor edges, obtaining a granularity degree at the photosensor that is edge edge dependent.

20. The process according to claim 19, wherein the granularity at the detector corners is higher than at any other detector zone.

21. The process according to claim 19, wherein the granularity at the detector edges is higher than at any other detector zone.

22. The process according to any of claims 19 to 21, wherein the number of signals to be read out is reduced:
- by joining signals,
- by using different photosensor elements at the center of the photosensor with regard to the remaining photosensor zones,
- combination of both.

23. The process according to claim 21, wherein the number of signals to be read out is reduced by joining signals in groups of at least two:
- at the detector center, or
- at the detector center and at the detector laterals, or
- at the detector center, at the detector laterals and at the detector corners.

24. The process according to claim 22, wherein the number of signals to be read out is reduced by using:
- smaller photosensor elements at the detector corners than at the detector center and detector laterals, or
- smaller photosensor elements at the detector corners, larger photosensor elements at the detector laterals and even larger photosensor elements at the detector center.

25. The process according to claim 22, wherein the number of signals to be read out is reduced by using photosensor elements of different shape within the detector.

26. A detector module to carry out the method defined in any of claims 1 to 19, or the process defined in any of claims 19 to 25, comprising photosensor elements with a larger active area at the center of the photosensor and smaller active area at the detector edges.

27. The detector module according to claim 26, wherein the larger active area at the center is obtained by summing the active area of two or more photosensor elements, or by using different photosensor elements within the photosensor array.

28. The detector module according to claim 26, comprising a photosensor array wherein photosensor elements located at the photosensor array center are merged into groups of at least two, and photosensor elements located at the photosensor array corners and laterals are not merged, or are merged in a smaller degree than at the center.

29. The detector module according to claim 26, comprising a photosensor array wherein photosensor elements located at the photosensor array center and laterals are merged into groups of at least two, and photosensor elements located at the photosensor array corners are not merged.

30. The detector module according to claim 26, wherein the larger active area at the center is obtained by using photosensor elements of different shape within the photosensor array.

31. The detector module according to claim 26, comprising a scintillation block selected from a monolithic crystal or a pixelated crystal.

## Amended claims

### Amended claims in accordance with Rule 137(2) EPC.

1. A method to reduce the number of signals to be read out in a detector **characterized in that** it comprises using a lower photosensor granularity at least at the center obtaining a granularity degree at the photosensor that is edge dependent, wherein "granularity" refers to the number of signals per area element.

2. The method according to claim 1, wherein the granularity at the detector corners is higher than at any other detector zone.

3. The method according to claim 1, wherein the granularity at the detector edges is higher than at any other detector zone.

4. The method according to any of claims 1 to 3, wherein the number of signals to be read out is reduced by joining signals in at least the center zone of the detector.

5. The method according to any of claims 1 to 3, wherein the number of signals to be read out is reduced by using different photosensor elements at the center of the photosensor with regard to the remaining photosensor zones.

6. The method according to claim 4, wherein the number of signals to be read out is reduced by joining signals:
- at the detector center, or
- at the detector center and at the detector laterals, or
- at the detector center, at the detector laterals and at the detector corners.

7. The method according to claim 5 or 6, wherein the number of signals to be read out is reduced by joining the signals in groups of at least two.

8. The method according to claim 5, wherein the number of signals to be read out is reduced by using smaller photosensor elements at the detector corners than at the detector center and detector laterals.

9. The method according to claim 5, wherein the number of signals to be read out is reduced by using smaller photosensor elements at the detector corners, larger photosensor elements at the detector laterals and even larger photosensor elements at the detector center.

10. The method according to claim 5, wherein the number of signals to be read out is reduced by using photosensor elements of different shape within the detector.

11. The method according to any of claims 4 or 5, wherein the number of signals to be read out is reduced by:
